# EUROPÄISCHE PATENTSCHRIFT

(11) **EP 2 144 711 B1**
(45) Veröffentlichungstag und Bekanntmachung des Hinweises auf die Patenterteilung: **31.05.2017**
(21) Anmeldenummer: 08735184.7
(22) Anmeldetag: 11.04.2008
(51) Int. Cl.: B81C 1/00, B05D 1/28, B82Y 30/00, B82Y 40/00

(54) **VERFAHREN ZUM ÜBERTRAGEN EINER NANOSCHICHT**
METHOD FOR TRANSFERRING A NANOLAYER
PROCÉDÉ DE TRANSFERT D'UNE NANOCOUCHE

(30) Priorität: 11.04.2007 DE 102007016995
(43) Veröffentlichungstag der Anmeldung: 20.01.2010
(73) Patentinhaber: CNM Technologies GmbH, 33609 Bielefeld (DE)
(72) Erfinder: Gölzhäuser, Armin, 33615 Bielefeld (DE); Nottbohm, Christoph, 89075 Ulm (DE); Beyer, André, 33719 Bielefeld (DE)
(74) Vertreter: Wegner, Hans
(86) Internationale Anmeldenummer: PCT/EP2008/002891
(87) Internationale Veröffentlichungsnummer: WO 2008/125302

(56) Entgegenhaltungen:
- WO-A-2005/033189

## Beschreibung

### 1. Technischer Bereich

Die Erfindung betrifft ein Verfahren zum Übertragen einer Nanoschicht von einem ersten Substrat auf ein zweites Substrat sowie ein mit diesem Verfahren mit einer Nanoschicht bedecktes TEM (Transmissionselektronenmikroskopie)-Substrat.

### 2. Der Stand der Technik

Die Herstellung und der Einsatz von Objekten mit Abmessungen im Nanometerbereich sind das Ziel der Nanotechnologie. Bekannt sind beispielsweise Nanosphären, Nanodrähte oder auch sogenannte "Nanotubes", die aus Kohlenstoff gefertigt werden. Letztere sind ein Bespiel dafür, dass Objekte der Nanotechnologie in einer Dimension durchaus makroskopische Abmessungen aufweisen können, während sie in einer oder mehreren anderen Raumrichtungen auf Ausdehnungen im Nanometerbereich begrenzt sind.

Ein weiteres, technisch wichtiges Beispiel sind Nanoschichten. Darunter wird im Folgenden eine Schicht aus einem beliebigen Material verstanden, die in zwei Raumrichtungen makroskopische Abmessungen aufweist, d.h. im Mikrometerbereich oder darüber, während die Dicke der Schicht auf maximal 10 nm begrenzt ist. Dabei muss die Nanoschicht nicht homogen ausgebildet sein, sondern kann z.B. mit Löchern, Linien o.ä. strukturiert sein.

Möglichkeiten zur Herstellung solcher Nanoschichten an sich sind seit langem bekannt, beispielsweise mit Hilfe der bekannten Langmuir-Blodgett-Technik. Ein anderer Ansatz sind selbst-aggregierende Monoschichten aus hochgeordneten organischen Molekülen, die an einer Substratoberfläche chemisorbiert sind. Die Herstellung solcher Schichten wird beispielsweise in der DE 199 45 935 A1 beschrieben. Darüber hinaus lassen sich Nanoschichten auch aus monoatomaren Graphit-Schichten herstellen, die beispielsweise durch Pyrolyse erzeugt werden vgl. z.B. Berger C. et al., Science 312, 1191 (2006), Rolling E, Gweon GH, Zhou SY, et al., Journal of Physics and Chemistry of Solids 67, 2172 (2006).sowie Hass et al. in Appl. Phys. Lett. 89, 143106 (2006)

Sämtliche dieser Schichten gewinnen jedoch nur dann technische Bedeutung, wenn es gelingt, sie in einfacher Weise manipulierbar zu machen, d.h. die Schicht
im Wesentlichen zerstörungsfrei von einer Unterlage (Substrat) auf eine andere Unterlage zu übertragen. In der Veröffentlichung *"* Freestanding Nanosheets from Crosslinked Biphenyl Self-Assembled Monolayers" in Adv. Mater. 2005, Bd. 17, S. 2583 - 2587 wird ein Verfahren beschrieben, bei dem die Nanoschicht durch Trennung der Bindung zum Substrat oder durch Auflösen des Substrats freigestellt werden kann. Allerdings wird dadurch noch kein kontrollierter Transfer auf ein anderes Substrat ermöglicht. Des Weiteren ist aus der Veröffentlichung von Meitl. et al. in Nature Materials, Bd. 5, 2006, S. 32 ein Verfahren bekannt, mit dem unter anderem dünne Schichten mit Hilfe eines Stempels aus Polydimethylsi-loxan von einem Substrat auf ein anderes übertragen werden können. Da die Adhesion zwischen Stempel und Substrat wesentlich von der Geschwindigkeit bestimmt wird, mit der der Stempel relativ zum Substrat bewegt wird, lässt sich dieses Verfahren nur bedingt technisch einsetzen.

Die PCT Anmeldung WO 2005 / 033 189 A1 offenbart ein Verfahren zum Anwenden eines strukturierten dünnen Films auf ein Substrat, wobei das Verfahren die Schritte umfasst: Behandeln eines Substrats mit einem Plasma; Anwenden eines flüssigen Beschichtungsstoffes, der eine oder mehrere Verbindungen umfasst, die aus der Gruppe der Organopolysiloxan-Polymere, Oganopolysiloxan-Oligomere, Siloxan-Harze und Polysilane ausgewählt werden, auf die Substratoberfläche durch eine weiche Lithographie-Drucktechnik, vorzugsweise ein Mikrokontaktdrucken, um einen strukturierten Film auf der Substratoberfläche zu bilden. Falls erforderlich, kann verbleibender Beschichtungsstoff von der Substratoberfläche entfernt werden. Der Prozess erfordert nicht, dass der flüssige Beschichtungsstoff einen Aushärtungsschritt durchläuft, wie er etwa in der Decal Transfer Microlithography Technik erforderlich ist. Geeignete Formen der Plasma-Behandlung können vor dem Drucken zum Aktivieren des Substrats benutzt werden.

Der vorliegenden Erfindung liegt daher das Problem zugrunde, ein Verfahren anzugeben, mit dem in einfacher Weise eine Nanoschicht von einem ersten Substrat auf ein zweites Substrat übertragen werden kann.

### 3. Zusammenfassung der Erfindung

Dieses Problem wird gemäß einem Aspekt der vorliegenden Erfindung gelöst durch ein Verfahren mit den Merkmalen nach Anspruch 1. Das Verfahren weist die folgenden Schritte auf:
a. Aufbringen eines Transfermediums auf die Nanoschicht, wobei das Transfermedium in diesem Schritt oder danach von einer flüssigen oder gasförmigen Phase in eine feste Phase umgewandelt wird;
b. Ablösen des Transfermediums und der Nanoschicht vom ersten Substrat; und
c. Aufbringen des Transfermediums und der Nanoschicht auf das zweite Substrat; und
d. Entfernen des Transfermediums.

Anders als im oben erläuterten Stand der Technik wird somit der Phasenübergang eines Transfermediums zur Handhabung der Nanoschicht verwendet. Nach dem Übergang in die feste Phase ist das Transfermedium vorzugsweise stabil gegenüber den weiteren Prozessschritten, kann aber in einem weiteren Prozessschritt selbst aufgelöst oder in sonstiger Weise von der Nanoschicht entfernt werden. Dazu kann das Transfermedium beispielsweise ein Photoresist umfassen.

Der Schritt b. in dem angegebenen Verfahren kann das Auflösen einer zwischen dem ersten Substrat und der Nanoschicht angeordneten Opferschicht umfassen. Bei der Opferschicht kann es sich um jede beliebige Schicht handeln, die durch geeignete chemische oder physikalische Verfahren beseitigt werden kann und dadurch die Ablösung der Nanoschicht vom ersten Substrat ermöglicht. Grundsätzlich denkbar sind jedoch auch andere Vorgehensweisen um die Bindung zwischen den ersten Substrat und der Nanoschicht zu beseitigen.

In einem Ausführungsbeispiel wird das im Schritt b. abgelöste Transfermedium und die Nanoschicht vor dem Aufbringen auf das zweite Substrat in eine Flüssigkeit, insbesondere Wasser, eingetaucht, wobei das Transfermedium und die Nanoschicht vorzugsweise auf der Flüssigkeitsoberfläche schwimmt. Das zweite Substrat wird im Schritt c. bevorzugt in die Flüssigkeit eingetaucht, so dass das Transfermedium und die Nanoschicht sich darauf absetzen können. Allerdings können das Transfermedium und die Nanoschicht auch zunächst in einer ersten Flüssigkeit auf ein Zwischensubstrat aufgebracht werden und nachfolgend in einer zweiten Flüssigkeit von dem Zwischensubstrat wieder abgelöst werden.

Besondere Bedeutung gewinnt das beschriebene Verfahren bei der Herstellung von Substraten für die Transmissionselektronenmikroskopie (TEM). Dazu ist es vorteilhaft, wenn das zweite Substrat insbesondere ein TEM-Netzchen ist, auf dem die Nanoschicht mit dem erläuterten Verfahren angeordnet wird. Ein solches TEM-Netzchen weist dann eine große Anzahl von Nanomembranen auf, die bei der Transmissionselektronenmikroskopie von darauf angeordneten Objekten ein hohes Maß an Kontrast sicherstellen.

### 4. Kurze Beschreibung der Zeichnungen

In der nachfolgenden detaillierten Beschreibung werden Ausführungsbeispiele der vorliegenden Erfindung unter Bezugnahme auf die begleitenden Figuren näher erläutert. Diese Figuren zeigen:
- Fig. 1:: Eine schematische Darstellung eines Ausführungsbeispiels des erfindungsgemäßen Verfahrens;
- Fig. 2:: Eine TEM-Aufnahme eines Ausführungsbeispiels eines TEM-Netzchens gemäß der vorliegenden Erfindung; und
- Fig. 3:: Eine schematische Darstellung einer Vorrichtung zur weitgehend automatisierten Durchführung eines Ausführungsbeispiels der Erfindung.

### 5. Detaillierte Beschreibung von bevorzugten Ausführungsbeispielen

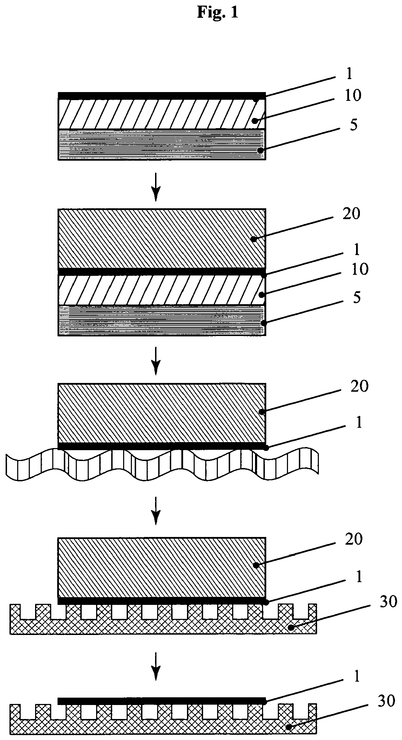

Zunächst wird anhand der Figur 1 eine Ausführung der vorliegenden Erfindung allgemein erklärt, bevor konkrete Realisierungen mit den Beispielen 1 bis 4 näher erläutert werden. Mit dem beschriebenen Verfahren können beliebige Nanoschichten von einem beliebigen Trägersubstrat abgelöst und auf eine beliebige andere Oberfläche übertragen werden.

Wie in Fig. 1 zu erkennen ist der Ausgangspunkt des erläuterten Verfahrens eine Nanoschicht 1, die auf einem Substrat 5 angeordnet ist. Zwischen dem Substrat 5 und der Nanoschicht 1 befindet sich eine Zwischenschicht, die im Zuge des Verfahrens aufgelöst wird und daher als Opferschicht 10 bezeichnet wird. Zu beachten ist, das die Darstellung in Fig. 1 schematisch ist und die Dicke der Nanoschicht im Vergleich zu der Dicke der anderen Schichten stark übertrieben ist. Wie bereits einleitend erwähnt kann die Nanoschicht 1 mit einer Vielzahl von Techniken auf dem Substrat 5 und der Opferschicht 10 angeordnet werden. Darüber hinaus ist es denkbar, dass die Nanoschicht durch photolithographische Bearbeitung oder andere Methoden in einer gewünschten Weise strukturiert worden ist. Ferner ist es möglich, die Nanoschicht vor Beginn des Transfers chemisch zu funktionalisieren, beispielsweise für spätere biologische Anwendungen.

Bei dem Substrat 5 kann es sich um eine Oberfläche handeln, die für die Präparation der Nanoschicht besonders gut geeignet ist, beispielsweise eine Oberfläche aus Au, Ag, Si, Si₃N₄, SiO₂, Fe oder auch andere geeignete Substratmaterialien. Allerdings könnte der Anfangszustand aus Fig. 1 auch durch andere vorhergehende Prozessschritte erreicht worden sein.

Im ersten Schritt des in Fig. 1 dargestellten Verfahrens wird das Transfermedium 20 auf das Trägersubstrat 5 mit der Opferschicht 10 und der Nanoschicht 1 aufgebracht. Im Ausführungsbeispiel aus Fig. 1 ist das **Transfermedium 20** zunächst flüssig oder gasförmig. Bei der Anordnung auf der Nanoschicht 1 oder unmittelbar nach diesem Schritt wird es in die feste Phase umgewandelt.

Im nächsten Schritt wird die Opferschicht 10 aufgelöst, beispielsweise durch ein geeignetes Lösungsmittel oder andere chemische oder physikalische Vorgehensweisen. Damit ist die Nanoschicht 1 vom Trägersubstrat 5 getrennt. Die mechanische Stabilität der Nanoschicht 1 wird in diesem Zustand durch das Transfermedium 20 gewährleistet. Allerdings ist es durchaus möglich, nicht nur ein einziges Transfermedium 20 aufzubringen, dass die mechanische Stabilität gewährleistet sondern mehrere oder sogar ein passendes Schichtsystem, beispielsweise zunächst ein Haftvermittler und dann eine besonders stabile Materialschicht (in Fig. 1 nicht dargestellt).

Es ist auch möglich auf eine Opferschicht zu verzichten und durch eine andere Methode eine Trennung der Nanoschicht vom Trägersubstrat herbeizuführen. So können beispielsweise die chemischen Bindungen zwischen der Nanoschicht und dem Trägersubstrat durch einen geeigneten (z.B. gasförmigen) Reaktionspartner aufgebrochen werden.

Im nächsten Schritt wird das Transfermedium 20 mit der Nanoschicht 1 auf das Zielsubstrat 30 (oder ein Zwischensubstrat, in Fig. 1 nicht dargestellt) übertragen. Dieser Prozessschritt wird durch die erhöhte mechanische Stabilität und Größe des Transfermediums 20 gegenüber der Übertragung einer reinen Nanoschicht 1 erleichtert bzw. überhaupt erst ermöglicht. Im letzten Schritt des Ausführungsbeispiels aus Fig. 1 wird schließlich das Transfermedium 20 entfernt, beispielsweise, indem es aufgelöst wird.

Im Folgenden werden konkrete Beispiele für Nanoschichten angegeben, die mit dem erläuterten Verfahren von einem Substrat auf ein anderes übertragen werden.

### Beispiel 1:

Die Übertragung einer vernetzten Monolage von 4'-[(3-Trimethoxysilyl) propoxy]-[1,1'-biphenyl]-4-carbonitril (im Folgenden Monolage (I)) auf ein TEM-Netzchen. Eine solche Monolage hat bedeutende Vorteile für die Elektronenmikroskopie. Die Schichtdicke ist durch die Länge der Monomere gegeben, aus denen die Monolage gebildet wird. Sie ist daher weitgehend homogen und beträgt ca. 1,5 nm. Herkömmliche TEM Substrate sind demgegenüber deutlich dicker, was zu einem geringeren Probenkontrast im TEM-Bild führt. Auf der Monolage (I) kann chemische Nanolithographie durchgeführt werden, vgl. Biebricher A. et al., Journal of Biotechnology 112, 97 (2004). Damit können beispielsweise organische Moleküle an wohl-definierte Positionen auf der Monolage (I) gebunden werden.

Zur Herstellung des beschichteten TEM-Netzchens wird die Monolage (I) zunächst auf einem mit Siliziumnitrid beschichtetem Siliziumsubstrat präpariert. Das Silizium wird in diesem Beispiel als Trägersubstrat verwendet; die Siliziumnitridschicht dient als Opferschicht und die Monolage (I) ist die zu übertragende Nanoschicht. Als Transfermedium wird ein Photoresist (z.B. AR-P 3510 von All-resist GmbH, www.allresist.de) benutzt. Der Resist wird auf das Trägersubstrat aufgeschleudert und auf einer Heizplatte ausgehärtet. Eine anschließende Behandlung mit Flusssäure (48%) löst die Opferschicht, d.h. das Siliziumnitrid, auf. Damit liegt der Photoresist mit der Monolage (I) nur noch lose auf dem Silizium. Durch vorsichtiges Herausnehmen und Wiedereintauchen (vorzugsweise in Wasser) löst sich der Photoresist vom Silizium und schwimmt auf der Flüssigkeitsoberfläche. Anschließend wird ein TEM-Netzchen als Zielsubstrat verwendet und mit einer Pinzette in das Wasser getaucht. Mit dem Zielsubstrat wird der schwimmende Photoresist "herausgefischt". Als letzten Schritt wird der Photolack in Aceton aufgelöst (4. Schritt).

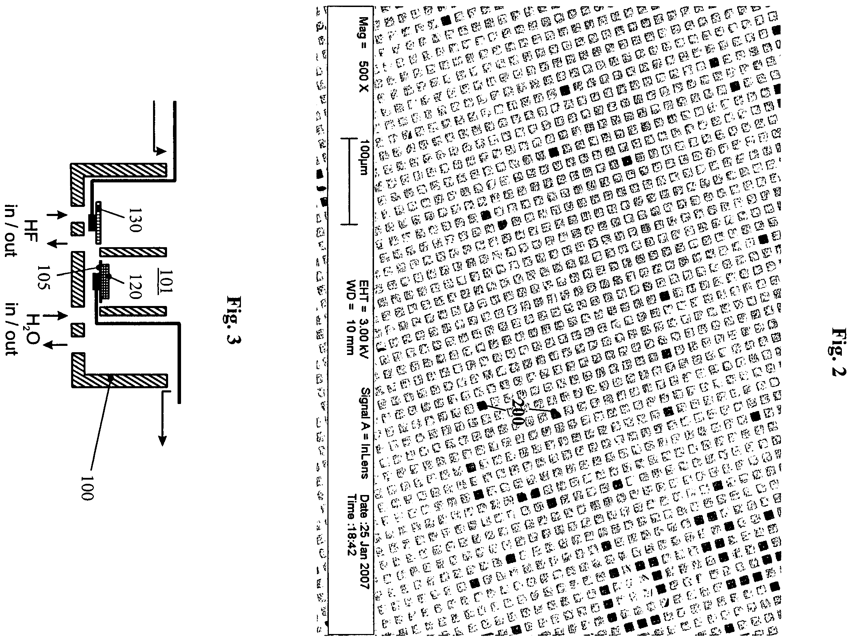

In Fig. 2 ist ein TEM-Netzchen (1500 mesh Au-Netz) mit darüber gespannter Monolage (I) gezeigt. Die übertragbare Fläche ist nur durch die Größe des Netzchens limitiert. Man erkennt, dass die Monolage nur an wenigen Stellen Defekte 200 aufweist (die dann dunkler im Bild erscheinen).

Durch die beschriebene Übertragung der Monolage (I) auf Standard TEM-Netzchen (z.B. ein Quantifoil-Netzchen von Quantifoil Micro Tools GmbH, www.quantifoil.com) können auf einmal mehr als 10.000 Membranen auf einem TEM-Netzchen erzeugt werden, die hinreichend stabil sind. Die Größe der einzelnen Membranflächen lässt sich einfach durch Verwendung verschiedener TEM-Netzchen variieren. Da die TEM-Netzchen vergleichsweise günstig sind, lassen sich mit dem erläuterten Verfahren in kostengünstiger Weise TEM-Substrate für einen hohen Probenkontrast herstellen.

Im TEM-Einsatz sind solche mit einer Nanoschicht versehenen TEM-Netzchen vorteilhaft gegenüber mit Kohlenstoff beschichteten TEM-Netzchen sowohl im Hinblick auf ihre mechanische Stabilität, als auch der Fähigkeit Elektronenstrahlen mit Energien von bis zu 200 keV zu widerstehen. Ein weiterer Vorteil ist der niedrige Hintergrundkontrast bei der Transmissionselektronenmikroskopie mit hoher Auflösung.

Das im Beispiel 1 vorgeschlagene Verfahren lässt sich mit relativ einfachen Mitteln für eine automatisierte Produktion anpassen. Dazu kann z.B. das in Fig. 3 schematisch dargestellte System verwendet werden. Es handelt sich dabei um einen flusssäurebeständigen Behälter 100 mit mehreren Kammern und Zu- bzw. Abflüssen für Wasser und Flusssäure. Die eigentliche Ätzkammer 101 ist so dimensioniert, dass ihre Grundfläche nur geringfügig größer ist als die des Trägersubstrates 105. Damit ist der Ort des schwimmenden Photolackes hinreichend definiert.

Der gesamte Übertragungsprozess lässt sich mit diesem Aufbau wie folgt durchführen:
Im ersten Schritt wird der Photoresist 120 wie bereits erläutert auf das Trägersubstrat 105 aufgebracht. Im zweiten Schritt wird diese Probe, wie in Fig. 3 gezeigt, in den Behälter eingebracht. Die Flusssäure wird eingelassen und damit die Opferschicht (nicht dargestellt in Fig. 3) aufgelöst. Die Flusssäure wird abgelassen und unmittelbar danach wird der Behälter mit Wasser gefüllt. Dabei löst sich der Photoresist vom Silizium und schwimmt auf der Wasseroberfläche. Nun kann die Siliziumprobe entfernt und das Zielsubstrat 130 eingebracht werden. Nachdem das Zielsubstrat den gleichen Ort wie das Trägersubstrat eingenommen hat (in Fig. 3 nicht dargestellt), kann das Wasser wieder abgelassen werden. Zum Abschluss muss der Photolack aufgelöst werden, beispielsweise mit Aceton.

### Beispiel 2:

Die Übertragung einer strukturierten Monolage (I) auf ein Goldsubstrat:
Nanoschichten aus selbst-aggregierenden Monolagen (SAM) können auf einer Vielzahl von Substraten präpariert werden. Dazu muss eine passende SAM-Substrat Kombination bekannt sein. Die Monolage kann z.B. als Resist zum naßchemischen Ätzen oder zur Metallabscheidung verwendet werden. Außerdem lassen sich durch "chemische Lithographie" (Bio)-Moleküle ankoppeln.

Für ein gegebenes Substrat ist jedoch nicht immer ein geeignetes Molekül vorhanden, um Monolagen zu erzeugen. Insbesondere ist es mit viel Aufwand verbunden, eine neue SAM-Substrat-Kombination zu erhalten und zu charakterisieren. Für lithographische Prozesse ist es außerdem in der Regel nötig, dass das Substrat flach ist.

Mit der erfindungsgemäßen Übertragung von Monolagen ist es jedoch möglich, bekannte SAM-Substrat-Kombinationen zu verwenden. Die vorausgehende lithographische Strukturierung kann auf einem flachen Substrat erfolgen. Die Übertragung kann dann sowohl auf gekrümmte Oberflächen erfolgen als auch auf Substrate, auf denen selbst kein SAM gebildet werden kann.

Das Beispiel 2 wird wie folgt ausgeführt: Die Monolage (I) wird auf einem mit Siliziumnitrid beschichtetem Siliziumsubstrat präpariert und mit photolithographischen Methoden (Photoresist aufspinnen, belichten, entwickeln, Behandlung mit Sauerstoff-Plasma, auflösen des Photoresists) strukturiert. Alternativ kann die Strukturierung auch elektronenlithographisch erfolgen. Die weiteren Prozessschritte sind im Beispiel 1 beschrieben. Anstelle eines TEM-Netzchens wird jedoch eine Goldoberfläche als Zielsubstrat verwendet und mit einer Pinzette in das Wasser getaucht. Mit dem Zielsubstrat wird der schwimmende Photoresist "herausgefischt". Zum Schluss wird der Photolack in Aceton aufgelöst.

Mit der Vorgehensweise gemäß dem zweiten Beispiel kann eine (strukturierte) Monolage (I) auf Goldsubstraten präpariert werden, was ohne den erläuterten Übertragungsprozess nicht möglich ist.

### Beispiel 3:

Die Übertragung einer 1,1'-biphenyl-4-thiol Monolage (im Folgenden Monolage (II)) auf ein Siliziumoxidsubstrat

In diesem Beispiels wird die Monolage (II) zunächst auf einem mit Gold beschichteten Glimmersubstrat präpariert. Das Glimmer dient hier als Trägersubstrat, das Gold als Opferschicht und die Monolage (II) ist die zu übertragende Monoschicht. Als Transfermedium wird ein Photoresist (z.B. AR-P 3510 von All-resist GmbH, www.allresist.de) benutzt. Der Resist wird auf das Trägersubstrat aufgeschleudert und auf einer Heizplatte ausgehärtet.

Im nächsten Schritt wird das Glimmersubstrat mit Klebeband (z.B. Scotch-Tape, von 3M) schichtweise abgetragen, alternativ kann es auch in Flußsäure aufgelöst werden. Anschließend wird das Gold (Opferschicht) entfernt (z.B. mit einer Iod/Kaliumiodid-Lösung oder Kaliumcyanidlösung), indem man die Probe auf der Ätzlösung aufschwimmen lässt. Mit einer Pinzette kann man nun eine Siliziumoxidprobe in die Lösung eintauchen und damit die Monolage (II) mit dem Photoresist "herausfischen". Optional kann man die Monolage (II) mit dem Photoresist vorher mit einem Hilfssubstrat aus der Ätzlösung "herausfischen" und in Wasser eintauchen, so dass der Transfer auf das Zielsubstrat nicht aus der Ätzlösung heraus geschehen muss. Zum Schluss wird auch hier der Photoresist in Aceton aufgelöst. Der Vorteil liegt auch in diesem Beispiel darin, dass die spezielle Monolage (II) ohne das beschriebene Verfahren auf Siliziumoxidsubstraten nicht präpariert werden kann.

### Beispiel 4:

Die Übertragung von Graphene (monoatomare Graphit-Schicht) auf TEM-Probenträger.

Freistehende Graphene-Schichten wurden von Geim et. al. präpariert (Meyer et al. Nature 2007 (446) 60)). Dazu wird mittels optischer Kontrolle ein geeignetes Stück Graphene ausgewählt und dann mittels Elektronenlithographie ein Metallgitter darüber aufgebracht. Danach wird das Substrat aufgelöst, so dass das Metallgitter mit dem Graphene zurückbleibt. Allerdings sind die Strukturierung mit Elektronenstrahllithographie und das anschließende Aufbringen von Metall prozesstechnisch sehr aufwändig und insbesondere für große Flächen nicht praktikabel.

Mit der in Beispiel 1 beschriebenen Methode lässt sich auch Graphene großflächig übertragen. Dazu könnte eine durch Pyrolyse auf SiC hergestellte Graphene Schicht als Ausgangsmaterial verwendet werden. Das SiC dient hier gleichzeitig als Trägersubstrat und Opferschicht. Nach dem Aufbringen des Transfermediums (z.B. eines Photoresists) wird das SiC durch photoelektrochemisches Ätzen in HF aufgelöst (siehe M. Köhler, "Ätzverfahren für die Mikrotechnik", WILEY-VCH Verlag, Weinheim, 1998, ISBN 3-527-28869-4, Seite 331). Bei diesem Ätzverfahren sind Ätzraten von bis zu 1,7 µm/s möglich. Anschließend kann das Transfermedium mit der Nanoschicht mit Hilfe eines Zwischensubstrates (z.B. Si) aus der HF Ätzlösung auf eine Wasseroberfläche übertragen werden. Die weiteren Schritte werden analog zu Beispiel 1 durchgeführt.

### Beispiel 5:

Die Herstellung von Nanoelektromechanischen Systemen (NEMS)

Die Monolage (I) kann mit dem in Beispiel 1 beschriebenen Verfahren auch auf eine entsprechend vorgefertigte NEMS-Struktur als aktives Element übertragen werden. Damit könnte beispielsweise ein akustischer Sensor bzw. ein Nanomikrophon hergestellt werden. Der Vorteil dieses Verfahrens besteht in der erhöhten Kompatibilität zu bestehenden Verfahren für die Herstellung von integrierten Schaltkreisen. Im ersten Schritt wird der NEMS-Trägerchip mit den entsprechenden Schaltkreisen hergestellt. Im zweiten Schritt wird die Monolage übertragen. Dabei stellen sich keine besonderen Anforderungen an die Widerstandsfähigkeit des NEMS-Trägerchips z.B. gegenüber Säuren, da der Chip beim Übertragen der Monolage (I) lediglich Wasser ausgesetzt ist.

## Patentansprüche

1. Verfahren zur Übertragung einer Nanoschicht (1) von einem ersten Substrat (5, 105) auf ein zweites Substrat (30,130), wobei die Nanoschicht (1) eine selbstaggregierende Monolage mit vernetzten Phenyl-Einheiten und/oder eine monoatomare Graphitschicht (Graphen) umfasst und das Verfahren die folgenden Schritte aufweist:
a. Aufbringen eines Transfermediums (20, 120) auf die Nanoschicht (1), wobei das Transfermedium (20, 120) in diesem Schritt oder danach von einer flüssigen oder gasförmigen Phase in eine feste Phase umgewandelt wird;
b. Ablösen des Transfermediums (20, 120) und der Nanoschicht (1) vom ersten Substrat (5, 105);
c. Aufbringen des Transfermediums (20, 120) und der Nanoschicht (1) auf das zweite Substrat (30, 130); und
d. Entfernen des Transfermediums (20, 120).

2. Verfahren nach Anspruch 1, wobei der Schritt b. das Auflösen einer zwischen dem ersten Substrat (5, 105) und der Nanoschicht angeordneten Opferschicht (10) umfasst.

3. Verfahren nach einem der vorhergehenden Ansprüche, wobei das im Schritt b. abgelöste Transfermedium (20, 120) und die Nanoschicht (1) vor dem Aufbringen auf das zweite Substrat (30, 130) in eine Flüssigkeit, insbesondere Wasser, eingetaucht wird.

4. Verfahren nach Anspruch 3, wobei das Transfermedium (20, 120) und die Nanoschicht (1) auf der Flüssigkeitsoberfläche schwimmt.

5. Verfahren nach einem der Ansprüche 3 oder 4, wobei das zweite Substrat (30, 130) im Schritt c. in die Flüssigkeit eingetaucht wird, so dass das Transfermedium (20, 120) und die Nanoschicht (1) sich darauf absetzen können.

6. Verfahren nach einem der vorhergehenden Ansprüche, wobei das Transfermedium (20, 120) im Schritt d. durch Auflösen entfernt wird.

7. Verfahren nach einem der vorhergehenden Ansprüche, wobei das Transfermedium ein Photoresist (20, 120) umfasst.

8. Verfahren nach einem der vorhergehenden Ansprüche, wobei die Nano-schicht (1) vor dem Schritt a. strukturiert wird, insbesondere durch photolithographische oder elektronenlithographische Verfahren.

9. Verfahren nach einem der vorhergehenden Ansprüche ferner aufweisend die Schritte des Aufbringens des Transfermediums (20,120) und der Nano schicht (1) auf ein Zwischensubstrat in einer ersten Flüssigkeit und des Ablösens des Transfermediums (20,120) von dem Zwischensubstrat in einer zweiten Flüssigkeit.

10. Verfahren nach einem der vorhergehenden Ansprüche, wobei die Nanoschicht eine selbstaggregierende Monolage mit vernetzten Bi- oder Terphenyleinheiten umfasst.

11. Verfahren nach einem der vorhergehenden Ansprüche, wobei die Nanoschicht (1) eine monoatomare Graphitschicht (Graphen) umfasst, die durch Pyrolyse erzeugt wird.

12. Verfahren nach einem der vorangehenden Ansprüche, wobei das zweite Substrat (30, 130) ein Substrat für die Transmissionselektronenmikroskopie (TEM), insbesondere ein TEM-Netzchen, ist.

13. TEM-Substrat (30,130), insbesondere TEM-Netzchen, mit einer darauf angeordneten Nanoschicht, hergestellt nach dem Verfahren nach Anspruch 12.

14. Nanoelektromechanisches System, insbesondere akustischer Sensor, mit einer Nanomembran hergestellt mit einem Verfahren nach einem der vorangehenden Ansprüche 1 - 11.

15. Abdeckung von beliebig geformten Öffnungen, mit einer Nanomembran, hergestellt mit einem Verfahren nach einem der vorhergehenden Ansprüche 1-11.

## Claims

1. A method for transferring a nano layer (1) from a first substrate (5, 105) to a second substrate (30, 130), wherein the nano layer (1) comprises a self-aggregating mono layer with cross-linked phenyl groups and / or a monoatomic graphite layer (graphene), and wherein the method comprises the following steps:
a. applying a transfer medium (20, 120) onto the nano layer (1), wherein the transfer medium (20, 120) is transformed from a liquid or a gaseous phase to a solid phase during this step or afterwards;
b. detaching the transfer medium (20, 120) and the nano layer (1) from the first substrate (5, 105);
c. applying the transfer medium (20, 120) and the nano layer (1) onto the second layer (30, 130); and
d. removing of the transfer medium (20, 120).

2. The method of claim 1, wherein step b. comprises dissolving a sacrificial layer (10) which is arranged between the first substrate (5, 105) and the nano layer.

3. The method of one of the preceding claims, wherein the transfer medium (20, 120) detached in step b. and the nano layer (1) are dipped into a liquid, in particular water, prior to applying the transfer medium or the nano layer (1) onto the second substrate (30, 130).

4. The method according to claim 3, wherein the transfer medium (20, 120) and the nano layer (1) float on the liquid surface.

5. The method according to claim 3 or 4, wherein the second substrate (30, 130) is dipped into the liquid during step c. so that the transfer medium (20, 120) and the nano layer (1) can settle on the second substrate (30, 130).

6. The method according to one of the preceding claims, wherein the transfer medium (20, 120) is removed by dissolving in step d.

7. The method according to one of the preceding claims, wherein the transfer medium comprises a photoresist (20, 120).

8. The method according to one of the preceding claims, wherein the nano layer (1) is structured prior to step a., in particular by photo-lithographic or electron-lithographic methods.

9. The method according to one of the preceding claims, further comprising the steps of: applying the transfer medium (20, 120) and the nano layer (1) onto an intermediate substrate in a first liquid and detaching the transfer medium (20, 120) from the intermediate substrate in a second liquid.

10. The method according to one of the preceding claims, wherein the nano layer comprises a self-aggregating monolayer with cross-linked biphenyl or terphenyl groups.

11. The method according to one of the preceding claims, wherein the nano layer comprises a mono-atomic graphite layer (graphene) generated by pyrolysis.

12. The method according to one of the preceding claims, wherein the second substrate (30, 130) is a substrate for the transmission electron microscopy (TEM), in particular a TEM grid.

13. A TEM substrate (30, 130), in particular a TEM grid, having a nano layer arranged thereon, wherein the TEM substrate (30, 130) is manufactured according to the method of claim 12.

14. A nano electro-mechanical system, in particular an acoustic sensor, having a nanomembrane fabricated by a method according to one of the claims 1 to 11.

15. A coverage of arbitrarily formed openings with a nanomembrane, wherein the nanomembrane is manufactured by a method according to one of the claims 1 to 11.

## Revendications

1. Procédé servant à transmettre une nanocouche (1) d'un premier substrat (5, 105) sur un deuxième substrat (30, 130), dans lequel la nanocouche (1) comprend une monocouche à agrégation automatique avec des motifs phényle réticulés et/ou une couche de graphite monoatomique (graphène) et le procédé présente les étapes suivantes consistant à :
a. appliquer un agent de transfert (20, 120) sur la nanocouche (1), dans lequel l'agent de transfert (20, 120) est transformé, lors de cette étape ou après, d'une phase liquide ou gazeuse en une phase solide ;
b. détacher l'agent de transfert (20, 120) et la nanocouche (1) du premier substrat (5, 105) ;
c. appliquer l'agent de transfert (20, 120) et la nanocouche (1) sur le deuxième substrat (30,130) ; et
d. supprimer l'agent de transfert (20, 120).

2. Procédé selon la revendication 1, dans lequel l'étape b. comprend la dissolution d'une couche sacrificielle (10) disposée entre le premier substrat (5, 105) et la nanocouche.

3. Procédé selon l'une quelconque des revendications précédentes, dans lequel l'agent de transfert (20, 120) détaché lors de l'étape b. et la nanocouche (1) sont, avant l'application sur le deuxième substrat (30, 130), plongés dans un liquide, en particulier dans de l'eau.

4. Procédé selon la revendication 3, dans lequel le milieu de transfert (20, 120) et la nanocouche (1) flottent à la surface du liquide.

5. Procédé selon l'une quelconque des revendications 3 ou 4, dans lequel le deuxième substrat (30, 130) est plongé, lors de l'étape c., dans le liquide, de sorte que l'agent de transfert (20, 120) et la nanocouche (1) puissent s'y déposer.

6. Procédé selon l'une quelconque des revendications précédentes, dans lequel l'agent de transfert (20, 120) est supprimé lors de l'étape d. par dissolution.

7. Procédé selon l'une quelconque des revendications précédentes, dans lequel l'agent de transfert comprend un photorésist (20, 120).

8. Procédé selon l'une quelconque des revendications précédentes, dans lequel la nanocouche (1) est structurée avant l'étape a., en particulier par un procédé de photolithographie ou de lithographie électronique.

9. Procédé selon l'une quelconque des revendications précédentes, présentant en outre les étapes consistant à appliquer l'agent de transfert (20, 120) et la nanocouche (1) sur un substrat intermédiaire dans un premier liquide et à détacher l'agent de transfert (20, 120) du substrat intermédiaire dans un deuxième liquide.

10. Procédé selon l'une quelconque des revendications précédentes, dans lequel la nanocouche comprend une monocouche à agrégation automatique avec des motifs de biphényle ou de terphényle réticulés.

11. Procédé selon l'une quelconque des revendications précédentes, dans lequel la nanocouche (1) comprend une couche de graphite monoatomique (graphène), qui est produite par pyrolyse.

12. Procédé selon l'une quelconque des revendications précédentes, dans lequel le deuxième substrat (30, 130) est un substrat pour une microscopie électronique à transmission (MET), en particulier une résille de MET.

13. Substrat de MET (30, 130), en particulier résille de MET, comprenant une nanocouche disposée sur lui-même, fabriqué selon le procédé selon la revendication 12.

14. Nanosystème électromécanique, en particulier capteur acoustique, comprenant une nanomembrane, fabriqué à l'aide d'un procédé selon l'une quelconque des revendications précédentes 1 - 11.

15. Système de recouvrement d'ouvertures à forme quelconque, comprenant une nanomembrane, fabriqué à l'aide d'un procédé selon l'une quelconque des revendications précédentes 1 - 11.
